(19) **Europäisches Patentamt**

**European Patent Office**

**Office européen des brevets**

(11) **EP 0 825 490 B1**

(12) **EUROPÄISCHE PATENTSCHRIFT**

(45) Veröffentlichungstag und Bekanntmachung des Hinweises auf die Patenterteilung:
**03.01.2001 Patentblatt 2001/01**

(51) Int Cl.⁷: $G03F\ 5/00$, $G03F\ 5/12$, $H04N\ 1/40$

(21) Anmeldenummer: **97810344.8**

(22) Anmeldetag: **04.06.1997**

(54) **Raster zur Simulation von Halbtonwerten auf einem Druckträger**

Raster for the simulation of halftone values on a printing medium

Trame pour la simulation de valeurs demi-teintes sur un support d'impression

(84) Benannte Vertragsstaaten:
**AT BE CH DE DK ES FI FR GB GR IE IT LI LU MC NL PT SE**

(30) Priorität: **19.08.1996 DE 19633288**

(43) Veröffentlichungstag der Anmeldung:
**25.02.1998 Patentblatt 1998/09**

(73) Patentinhaber: **National Zeitung und Basler Nachrichten AG**
**4002 Basel (CH)**

(72) Erfinder:
• **Blattner, Alfred**
**68220 Leymen (FR)**
• **Hieber, Peter**
**4153 Reinach (CH)**
• **Häny, Thomas**
**4055 Basel (CH)**

(74) Vertreter: **Bollhalder, Renato et al**
**Braun Héritier Eschmann AG**
**Patentanwälte VSP**
**Holbeinstrasse 36-38**
**Postfach 160**
**4003 Basel (CH)**

(56) Entgegenhaltungen:
**EP-A- 0 527 655          EP-A- 0 774 857**
**WO-A-94/19900          DE-A- 2 917 242**

## Beschreibung

Die vorliegende Erfindung bezieht sich auf einen Raster zur Simulation von Halbtonwerten auf einem Druckträger, wie er im Oberbegriff des unabhängigen Patentanspruchs 1 definiert ist.

Der Begriff "Raster" wird in der Drucktechnik verschiedenartig verwendet. Im Rahmen dieser Patentanmeldung bezeichnet er eine Vielzahl von regelmässig angeordneten Rasterpunkten, unabhängig davon, wie dies technisch realisiert wird. Die technische Umsetzung kann sowohl in Form eines physischen Rasters, wie z.B. Distanzraster, Kontaktraster oder Effektraster, als auch in Form eines elektronischen, virtuellen Rasters, z.B. mittels PostScript®-Befehlen aufgebaut, erfolgen.

Raster der eingangs erwähnten Art werden beispielsweise beim Offset-Druck, insbesondere rotativem Offset-Druck, verwendet. Beim rotativen Offset-Druck wird eine Druckplatte auf einen Plattenzylinder gespannt. Der Plattenzylinder arbeitet mit einem mit einem Gummituch bezogenen Zylinder zusammen und dieser wiederum mit einem Gegendruckzylinder, über den das zu bedruckende Papier geführt ist. Die druckenden Stellen der Druckplatten sind so präpariert, dass sie Wasser abstossen und die fettige Druckfarbe annehmen. Die nichtdruckenden Stellen sind wasserfreundlich präpariert und stossen die fettige Farbe ab. Beim Drucken wird zuerst die ganze Druckplatte angefeuchtet, wobei nur die nichtdruckenden, wasserfreundlichen Stellen das Wasser annehmen. Die teilweise feuchte Druckplatte läuft dann an Farbwalzen vorbei, die fettige Farbe auf die nicht feuchten Stellen der Druckplatte auftragen. Danach wird das Druckbild von der Druckplatte auf den Gummituchzylinder und von dem auf das zu bedruckende Papier übertragen.

Die zu färbenden Stellen eines Druckbilds bestehen aus einer Vielzahl von Rasterpunkten, die von blossem Auge nicht zu erkennen sind. Jeder Rasterpunkt ist durch Stege von den benachbarten Rasterpunkten getrennt. Die Stege werden nicht gefärbt. Je grösser die Gesamtfläche der Stege (nicht druckende Stellen) in einem Bildbereich ist, desto heller erscheint der Bildbereich. Der Anteil der gefärbten Fläche an der Gesamtfläche eines Bildbereichs definiert einen Grauwert, den Halbtonwert des Bildbereichs, und wird normalerweise in Prozenten angegeben.

Mittels eines Rasters mit einer Vielzahl von schachbrettartig angeordneten, imaginären Rasterzellen, in denen je ein Rasterpunkt angeordnet ist, können durch Variieren der Rasterpunktgrösse auf einem Druckträger unterschiedliche Halbtonwerte simuliert werden. Es ist bekannt, die Rasterpunkte derartiger Raster im wesentlichen rund oder elliptisch auszubilden, wobei für gewisse Tonwerte die Rasterpunkte auch quadratische Formen annehmen können. Diese runden oder elliptischen Rasterpunkte weisen aber den Nachteil auf, dass schon bei mittleren Rasterpunktgrössen, also bei mittlerem Halbtonwert des betreffenden Bildbereichs, ein Punkteschluss auftritt, so dass die Konturenschärfe sowie die Schattierungsverläufe des Druckbildes unbefriedigend sind.

Aus der DE-A-29 17 242 sind Rasterpunkte verschiedener Form bekannt, unter anderem rhombenförmige und elliptische, die sich bei Erhöhung des Halbtonwerts zunächst jeweils nur an zwei Ecken bzw. Enden berühren. Auch hier tritt bereits relativ rasch ein Punkteschluss mit den damit verbundenen Nachteilen auf.

Der Erfindung liegt daher die Aufgabe zugrunde, einen Raster der eingangs erwähnten Art zu schaffen, der schärfere Reproduktionen und feinere, weichere Verläufe in den Schattierungen ermöglicht.

Diese Aufgabe wird durch den erfindungsgemässen Raster gelöst, wie er im unabhängigen Patentanspruch 1 definiert ist. Bevorzugte Ausführungsvarianten ergeben sich aus den abhängigen Patentansprüchen. Der unabhängige Patentanspruch 11 bezieht sich auf ein Verfahren zur Simulation von Halbtonwerten auf einem Druckträger mit einem derartigen Raster.

Das Wesen der Erfindung besteht darin, dass bei einem Raster zur Simulation von Halbtonwerten auf einem Druckträger, mit einer Vielzahl von schachbrettartig angeordneten, imaginären Rasterzellen, in denen je ein Rasterpunkt angeordnet ist, die Rasterpunkte so geformt und angeordnet sind, dass bei über die Rasterzellen gleichbleibendem, beliebigem Tonwert für alle Punkte der Begrenzungslinien eines Rasterpunkts der jeweils kürzeste Abstand zum benachbarten Rasterpunkt gleich gross ist.

Mit anderen Worten, die Stege zwischen benachbarten Rasterpunkten sind bei über die Rasterzellen gleichbleibendem Tonwert überall gleich breit. Je grösser der Halbtonwert des Bildbereichs ist, desto grösser sind die betreffenden Rasterpunkte und desto schmaler die Stege zwischen den Rasterpunkten. Bei einer ständigen Vergrösserung des Halbtonwerts werden die Stege immer schmaler, bis sie schliesslich bei einem Halbtonwert von 100% ganz verschwinden. Theoretisch tritt beim erfindungsgemässen Raster erst bei einem Halbtonwert von 100% ein Punkteschluss auf, in der Praxis kommt es aber dadurch, dass die Rasterpunkte aus Pixeln zusammengesetzt sind, und aufgrund von Druckträgerunregelmässigkeiten schon ab einem Halbtonwert von etwa 85% zu einem Punkteschluss. Dieser Schwellwert wird durch eine Korrekturfunktion (Gradationskurve) auf über 95% erhöht.

Beim erfindungsgemässen Raster tritt ein Punkteschluss also erst bei einem viel grösseren Halbtonwert des Bildbereichs auf als bei den herkömmlichen Rastern, so dass schärfere Konturen, weichere Übergänge in den Mitteltönen und stärker durchgezeichnete Tiefenpartien erzielbar sind. Weiter erreicht man im Druck kürzere Einrichtzeiten, kürzere Vorlaufzeiten und eine bessere Farbführung im Fortdruck.

Vorzugsweise hat jeder Rasterpunkt eine im wesentlichen rhomboide Fläche, deren Begrenzungslinien derart bogenförmig verlaufen, dass sie zwei einander diagonal gegenüberliegende spitze Ecken und zwei einander diagonal gegenüberliegende runde oder stumpfe Ecken ausbilden. Mit stumpfer Ecke ist eine Ecke gemeint, die einen Winkel > 90° einschliesst, und mit runder Ecke ein Begrenzungslinienbereich mit relativ kleinem Bogenradius (Eckenradius). Der einzelne Rasterpunkt sieht dann im allgemeinen wie eine wehende Flagge aus. Weiter bevorzugte Rasterpunktformen sind in den Patentansprüchen 3 bis 6 definiert.

Eine Ausführungsvariante des erfindungsgemässen Rasters ist dadurch gekennzeichnet, dass bei einem kleineren Tonwert eines Rasterpunkts - d.h. bei einem kleineren Rasterpunkt - die runden Ecken einen grösseren Eckenradius aufweisen bzw. die stumpfen Ecken einen grösseren Winkel einschliessen und die spitzen Ecken einen kleineren Winkel einschliessen. Dies bewirkt einen weicheren Übergang in den gewünschten Farbeffekten, z.B. bei Hauttönen. Je feiner die Farbtöne und Farbnuancen sein sollen, desto langgestreckter, also mit grösseren Eckenradien der runden Ecken oder mit stumpferen Winkeln der stumpfen Ecken, sollte die Rasterpunktform sein.

Bei einer bevorzugten Ausführungsvariante des erfindungsgemässen Rasters ist jeder Rasterpunkt innerhalb seiner Rasterzelle gegenüber dem Rasterpunkt mit Tonwert 100% gedreht angeordnet, wenn sein Tonwert in einem bestimmten Tonwertbereich liegt. Die positiven Eigenschaften des erfindungsgemässen Rasters, d.h. schärfere Konturen, weichere Übergänge in den Mitteltönen und stärker durchgezeichnete Tiefenpartien, werden dadurch noch optimiert.

Allgemein ist mit dem erfindungsgemässen Raster die Vervielfältigung von Filmen oder die Herstellung von Druckplatten problemlos. Ausserdem kann er bei den bekannten Druckeinheiten als Ersatz für bisherige Raster verwendet werden, so dass keine kostspieligen Umrüstungen notwendig sind.

Im folgenden wird der erfindungsgemässe Raster unter Bezugnahme auf die beigefügten Zeichnungen und anhand von zwei Ausführungsbeispielen detaillierter beschrieben. Es zeigen:

Fig. 1 -    schematisch einen Schnitt durch die Druckeinheit einer bekannten Offset-Druckmaschine;

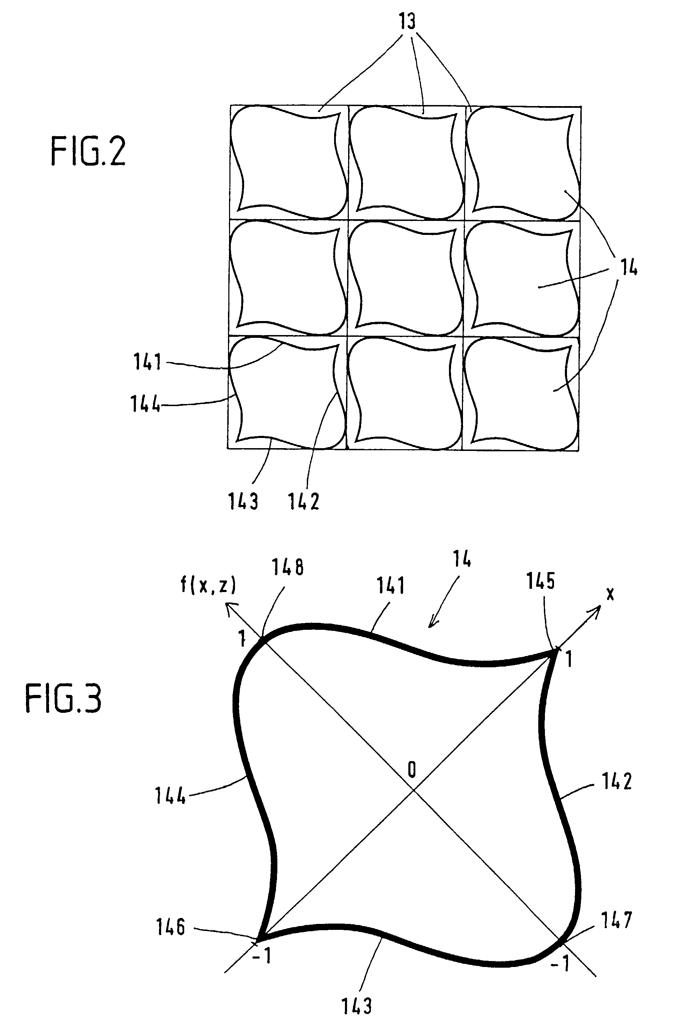

Fig. 2 -    einen stark vergrösserten Ausschnitt aus einem ersten Ausführungsbeispiel eines erfindungsgemässen Rasters mit über die Rasterzellen gleichbleibendem Tonwert;

Fig. 3 -    einen in noch stärkerer Vergrösserung dargestellten Rasterpunkt des Rasters von Fig. 2;

Fig. 4 -    einen stark vergrössert dargestellten Rasterpunkt eines zweiten Ausführungsbeispiels eines erfindungsgemässen Rasters;

Fig. 5 -    den Rasterpunkt von Fig. 3 in ungedrehter und gedrehter Stellung und

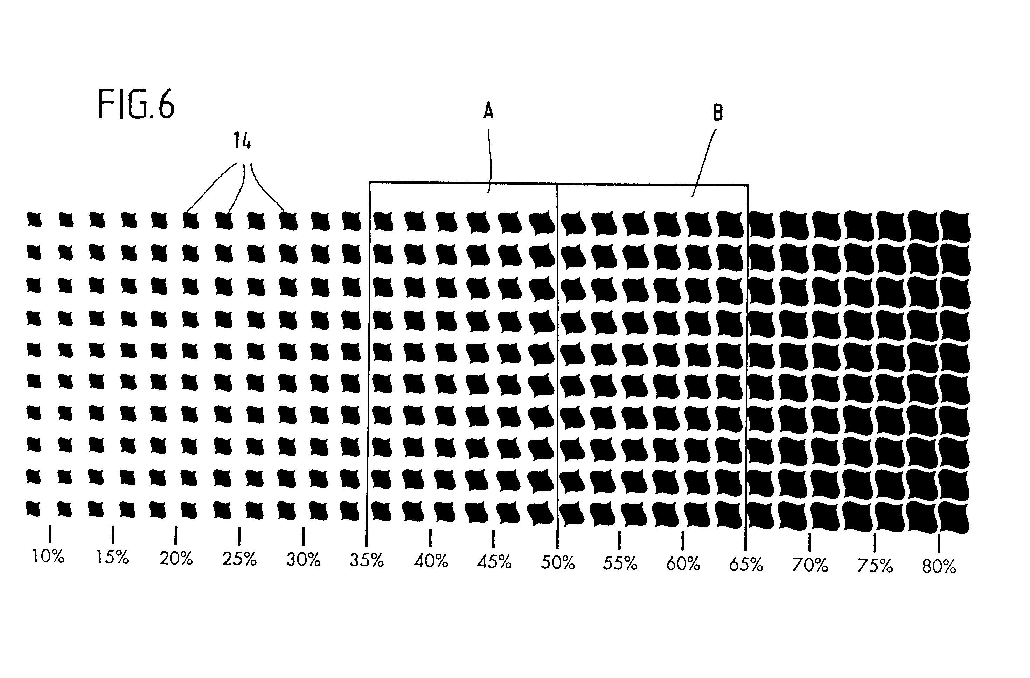

Fig. 6 -    einen stark vergrösserten Ausschnitt aus einem Raster mit Rasterzellen mit unterschiedlichen Tonwerten.

Figur 1

Die dargestellte Druckeinheit weist einen Plattenzylinder 1 auf, auf den eine Druckplatte 2 aufgespannt ist. Der Plattenzylinder 1 arbeitet einerseits mit einem Farbwerk 6 und einem Feuchtwerk 7 und andererseits mit einem Gummituchzylinder 3 und dieser seinerseits mit einem Gegendruckzylinder 5 zusammen, der mit einem zu bedruckenden Druckträger 4, z.B. Papier, bespannt ist. Die Übertragung von Druckfarbe 60 auf die Druckplatte 2 durch das Farbwerk 6 erfolgt über eine Anzahl von Druckwalzen 8 und die Übertragung von Wasser 70 durch das Feuchtwerk 7 über eine Anzahl von Übertragungswalzen 9. Alle Walzen bzw. Zylinder arbeiten gegenläufig zueinander, wie teilweise durch Pfeile angegeben.

Durch das Feuchtwerk 7 wird Wasser 70 an nichtdruckende Stellen 10 der Druckplatte 2 übertragen, während die druckenden Stellen 11 der Druckplatte 2 von Wasser befreit bleiben. Die feuchten Stellen 10 stossen die Druckfarbe 60 an den Auflagestellen 12 der aufliegenden Druckwalzen 8 ab, während die druckenden Stellen 11 die Druckfarbe annehmen. Die Druckfarbe wird dann von der Druckplatte 2 auf den Gummituchzylinder 3 übertragen und bildet dort Farbstellen 11', die schliesslich auf den Druckträger 4 gedruckt werden.

Die druckenden Stellen 11 bzw. Farbstellen 11' sind sehr kleine, von blossem Auge nicht voneinander zu trennende Rasterpunkte, die zusammen einen Raster bilden.

Figur 2

Der dargestellte Ausschnitt aus einem erfindungsgemässen Raster umfasst neun schachbrettartig angeordnete, imaginäre Rasterzellen 13, in denen je ein Rasterpunkt 14 angeordnet ist. Die Rasterpunkte sind jeweils durch vier Begrenzungslinien 141 bis 144 begrenzt. Die Begrenzungslinien der Rasterzellen 13 dienen nur zur Erläuterung der Aufteilung einer Druckplatte und existieren in Wirklichkeit nicht. Der Tonwert ist hier bei allen Rasterzellen 13 gleich, so dass alle Rasterpunkte 14 gleich gross sind.

Die Rasterpunkte 14 sind so geformt und angeordnet, dass für alle Punkte der Begrenzungslinien 141 bis 144 eines Rasterpunkts 14 der jeweils kürzeste Abstand zum benachbarten Rasterpunkt 14 gleich gross ist. Dies gilt auch dann, wenn die Rasterzellen 13 einen beliebigen anderen als den dargestellten Tonwert aufweisen, die Rasterpunkte 14 also grösser oder kleiner - aber alle gleich gross - sind.

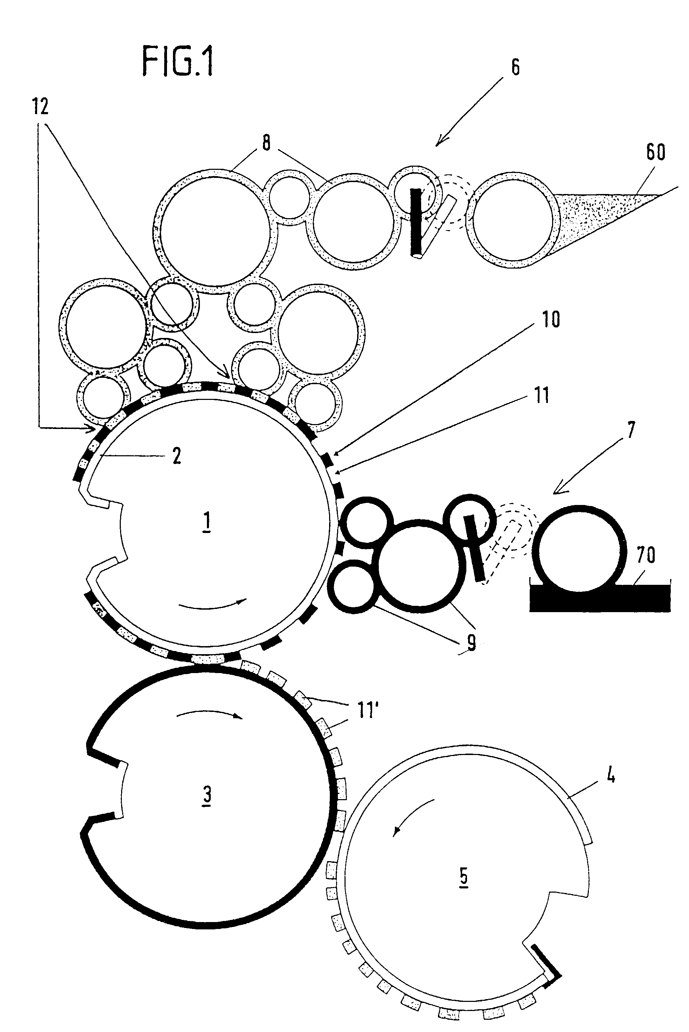

Die Bereiche zwischen den Rasterpunkten 14 werden Stege genannt und entsprechen den nichtdruckenden Stellen 10 der Druckplatte 2 in Fig. 1.

Figur 3

Der dargestellte Rasterpunkt 14 hat eine im wesentlichen rhomboide Fläche, deren Begrenzungslinien 141 bis 144 derart bogenförmig verlaufen, dass sie zwei einander diagonal gegenüberliegende spitze Ecken 145 und 146 und zwei einander diagonal gegenüberliegende runde Ecken 147 und 148 ausbilden. Die jeweils einander gegenüberliegenden Begrenzungslinien 141 und 143 bzw. 142 und 144 verlaufen parallel zueinander.

Die Begrenzungslinien 141 bis 144 können mit Ausnahme der Bereiche der spitzen Ecken, d.h. über mehr als 95% ihrer Länge, mathematisch durch die Funktion f(x,z) definiert werden:

$$f(x,z) = \pm z \cdot e^{-\sum\limits_{i=1}^{\infty} k_i \cdot \left(\frac{x}{z}\right)^{2i}} \; ;$$

wobei

e = Eulersche Zahl;
$x \in [-0.95, 0.95]$ ;

$$z = 2 \cdot \sqrt{\frac{Tonwert}{100\%}} - 1 \; ;$$

Tonwert $\in [0\%, 100\%]$ und
$k_i \in R_0^+$ wählbare Parameter sind.

Beim dargestellten Rasterpunkt ist $k_1 = 1.15$, $k_2 = 0.805$, $k_3 = 2.3$ und $k_i = 0 \; \forall \; i \geq 4$. Die x-Achse verläuft durch die beiden spitzen Ecken 145 und 146, während die f(x,z)-Achse durch die beiden runden Ecken 147 und 148 verläuft. Mit dieser Formel ergeben sich für jeden Halbtonwert eines Bildbereichs Rasterpunkte einer bestimmten Grösse.

Figur 4

Dieser Rasterpunkt 15 hat eine im wesentlichen rhomboide Fläche, die durch vier sinusförmige Begrenzungslinien 151 bis 154 begrenzt ist. Diese bilden zwei einander diagonal gegenüberliegende spitze Ecken 155 und 156 und zwei einander diagonal gegenüberliegende stumpfe Ecken 157 und 158 aus. Die jeweils einander gegenüberliegenden Begrenzungslinien 151 und 153 bzw. 152 und 154 verlaufen parallel zueinander.

Figur 5

Um schärfere Konturen, weichere Übergänge in den Mitteltönen und stärker durchgezeichnete Tiefenpartien zu erhalten, ist vorzugsweise jeder Rasterpunkt innerhalb seiner Rasterzelle gegenüber dem Rasterpunkt mit Tonwert 100% gedreht angeordnet, wenn sein Tonwert in einem bestimmten Tonwertbereich liegt. Ein um einen Drehwinkel a gedrehter Rasterpunkt 14 ist hier hinter einem ungedrehten Rasterpunkt 14' schwarz ausgefüllt dargestellt.

Der Drehwinkel $\alpha$ ist für

$$z=2\cdot\sqrt{\frac{Tonwert}{100\%}}-1$$

wie folgt definiert:

$$\forall\ z<z_{min}:\qquad\alpha=0°$$

$$\forall\ z\ \text{mit}\ z_{min}\leq z<z_{wp}:\qquad\alpha=\alpha_{max}\cdot\frac{z-z_{min}}{z_{wp}-z_{min}}$$

$$\forall\ z\ \text{mit}\ z_{wp}\leq z\leq z_{max}:\qquad\alpha=\alpha_{max}\cdot\frac{z_{max}-z}{z_{max}-z_{wp}}$$

$$\forall\ z>z_{max}:\qquad\alpha=0°$$

wobei $z_{min}$, $z_{max}$, $z_{wp}$ und $\alpha_{max}$ wählbare Parameter mit $0\leq z_{min}<z_{wp}<z_{max}\leq 1$ und $\alpha_{max}\in[0°,180]$ sind. Beim dargestellten Ausführungsbeispiel ist $z_{min}=0.183$ (entspricht einem Tonwert von 35%), $z_{max}=0.612$ (entspricht einem Tonwert von 65%), $z_{wp}=0.414$ (entspricht einem Tonwert von 50%) und $\alpha_{max}=15°$.

Figur 6

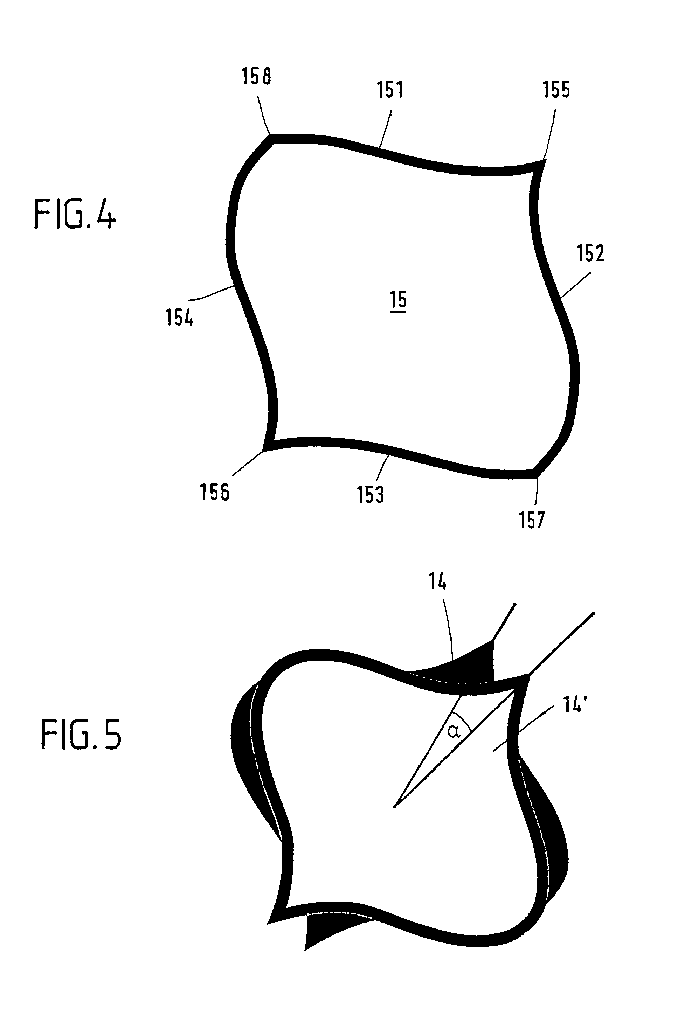

Der dargestellte Raster weist unterschiedlich grosse Rasterpunkte 14 auf, d.h. es sind Bildbereiche mit unterschiedlichen Halbtonwerten vorhanden. Für die Drehung der Rasterpunkte 14 gelten die im Zusammenhang mit Fig. 5 genannten Formel und die dort gewählten Parameter.

Liegt der Tonwert eines Rasterpunkts 14 zwischen 35% und 50%, also im Bereich A, so ist der Drehwinkel umso grösser, je grösser der Tonwert ist. Liegt der Tonwert eines Rasterpunkts 14 zwischen 50% und 65%, also im Bereich B, so ist der Drehwinkel umso grösser, je kleiner der Tonwert ist. Der maximale Drehwinkel von 15° wird bei einem Tonwert von 50% erreicht.

Zu den vorbeschriebenen Rastern sind weitere Variationen realisierbar. Hier ausdrücklich erwähnt sei noch, dass die Begrenzungslinien der Rasterpunkte auch kompliziertere Formen als die der Ausführungsbeispiele aufweisen können.

**Patentansprüche**

1. Raster zur Simulation von Halbtonwerten auf einem Druckträger (4), mit einer Vielzahl von schachbrettartig angeordneten, imaginären Rasterzellen (13), in denen je ein Rasterpunkt (14;14';15) angeordnet ist, dadurch gekennzeichnet, dass die Rasterpunkte (14;14';15) so geformt und angeordnet sind, dass bei über die Rasterzellen (13) gleichbleibendem, beliebigem Tonwert für alle Punkte der Begrenzungslinien (141-144;151-154) eines Rasterpunkts (14;14';15) der jeweils kürzeste Abstand zum benachbarten Rasterpunkt (14; 14';15) gleich gross ist.

2. Raster nach Anspruch 1, dadurch gekennzeichnet, dass jeder Rasterpunkt (14;14';15) eine im wesentlichen rhomboide Fläche hat, deren Begrenzungslinien (141-144;151-154) derart bogenförmig verlaufen, dass sie zwei einander diagonal gegenüberliegende spitze Ecken (145,146;155,156) und zwei einander diagonal gegenüberliegende runde (147,148) oder stumpfe (157,158) Ecken ausbilden.

3. Raster nach Anspruch 1 oder 2, dadurch gekennzeichnet, dass jeweils die einander gegenüberliegenden Begrenzungslinien (141-144;151-154) eines Rasterpunkts (14;14';15) parallel zueinander verlaufen.

4. Raster nach einem der Ansprüche 1 bis 3, dadurch gekennzeichnet, dass die Begrenzungslinien (141-144; 151-154) eines Rasterpunkts (14;14';15) mathematisch durch die Funktion f(x,z) definiert sind:

$$f(x,z) = \pm z \cdot e^{-\sum\limits_{i=1}^{\infty} k_i \cdot \left(\frac{x}{z}\right)^{2i}} \cdot g(x);$$

wobei

e = Eulersche Zahl;
$x \in [-1,1]$;

$$z = 2 \cdot \sqrt{\frac{Tonwert}{100\%}} - 1;$$

Tonwert $\in [0\%, 100\%]$ ;
$k_i \in R_0^+$ wählbare Parameter sind und
g(x) eine differenzierbare Funktion mit $0.9 \leq g(x) \leq 1.1$ und $g(-1) = g(1) = 0$

ist.

5. Raster nach einem der Ansprüche 1 bis 3, dadurch gekennzeichnet, dass die Begrenzungslinien (141-144) eines Rasterpunkts (14;14') mit Ausnahme der Bereiche der spitzen Ecken mathematisch durch die Funktion f(x,z) definiert sind:

$$f(x,z) = \pm z \cdot e^{-\sum\limits_{i=1}^{\infty} k_i \cdot \left(\frac{x}{z}\right)^{2i}};$$

wobei

e = Eulersche Zahl;
$x \in [-0.95, 0.95]$;

$$z = 2 \cdot \sqrt{\frac{Tonwert}{100\%}} - 1;$$

Tonwert $\in [0\%, 100\%]$ und
$k_i \in R_0^+$ wählbare Parameter

sind.

6. Raster nach einem der Ansprüche 1 bis 3, dadurch gekennzeichnet, dass jeder Rasterpunkt (15) durch vier sinusförmige Begrenzungslinien (151-154) begrenzt ist.

7. Raster nach einem der Ansprüche 1 bis 6, dadurch gekennzeichnet, dass bei einem kleineren Tonwert eines Rasterpunkts (14;14';15) die runden Ecken (147,148) einen grösseren Eckenradius aufweisen bzw. die stumpfen Ecken (157,158) einen grösseren Winkel einschliessen und die spitzen Ecken (145,146;155,156) einen kleineren Winkel einschliessen.

8. Raster nach einem der Ansprüche 1 bis 7, dadurch gekennzeichnet, dass jeder Rasterpunkt (14;14';15) innerhalb seiner Rasterzelle (13) gegenüber dem Rasterpunkt (14;15) mit Tonwert 100% gedreht angeordnet ist, wenn sein Tonwert in einem bestimmten Tonwertbereich liegt.

9. Raster nach Anspruch 8, dadurch gekennzeichnet, dass der Drehwinkel $\alpha$ für

$$z = 2 \cdot \sqrt{\frac{Tonwert}{100\%}} - 1$$

wie folgt definiert ist:

$$\forall\ z < z_{min}: \qquad \alpha = 0°$$

$$\forall\ z\ \text{mit}\ z_{min} \leq z < z_{wp}: \qquad \alpha = \alpha_{max} \cdot \frac{z - z_{min}}{z_{wp} - z_{min}}$$

$$\forall\ z\ \text{mit}\ z_{wp} \leq z \leq z_{max}: \qquad \alpha = \alpha_{max} \cdot \frac{z_{max} - z}{z_{max} - z_{wp}}$$

$$\forall\ z > z_{max}: \qquad \alpha = 0°$$

wobei $z_{min}$, $z_{max}$, $z_{wp}$ und $\alpha_{max}$ wählbare Parameter mit $0 \leq z_{min} < z_{wp} < z_{max} \leq 1$ und $\alpha_{max} \in [0°, 180]$ sind und insbesondere $z_{min} = 0.183$ und/oder $z_{max} = 0.612$ und/oder $z_{wp} = 0.414$ und/oder $\alpha_{max} = 15°$ sein können.

10. Raster nach einem der Ansprüche 1 bis 7, dadurch gekennzeichnet, dass die Verbindungslinie der beiden einander gegenüberliegenden Ecken der Rasterpunkte (14;14';15) in zwei diagonal benachbarten Rasterzellen (13) durch die gemeinsame Ecke der beiden Rasterzellen (13) geht.

11. Verfahren zur Simulation von Halbtonwerten auf einem Druckträger (4), dadurch gekennzeichnet, dass ein Raster nach einem der Ansprüche 1 bis 10 auf den Druckträger (4) gedruckt wird.

**Claims**

1. Screen for the simulation of halftone values on a printing medium (4), having a large number of imaginary screen cells (13) which are arranged in the manner of a chess board and in each of which a screen dot (14; 14'; 15) is arranged, characterized in that the screen dots (14; 14'; 15) are shaped and arranged in such a way that in the case of an arbitrary tonal value remaining constant over the screen cells (13), for all points on the boundary lines (141-144; 151-154) of a screen dot (14; 14'; 15), the respective shortest distance to the adjacent screen dot (14; 14'; 15) is of equal size.

2. Screen according to Claim 1, characterized in that each screen dot (14; 14'; 15) has an essentially rhomboidal area, whose boundary lines (141-144; 151-154) run in curves in such a way that they form two mutually diagonally opposite sharp corners (145, 146; 155, 156) and two mutually diagonally opposite round (147, 148) or blunt (157, 158) corners.

3. Screen according to Claim 1 or 2, characterized in that in each case the mutually opposite boundary lines (141-144; 151-154) of a screen dot (14; 14'; 15) run parallel to each other.

4. Screen according to one of Claims 1 to 3, characterized in that the boundary lines (141-144; 151-154) of a screen dot (14; 14'; 15) are defined mathematically by the function f(x,z)

$$f(x,z)=\pm z\cdot e^{-\sum_{i=1}^{\infty}k_i\cdot\left(\frac{z}{2}\right)^{2i}}\cdot g(x);$$

where

e = Euler's number;
$x\in[-1, 1]$ ;

$$z = 2\cdot\sqrt{\frac{tonal\ value}{100\%}}-1;$$

tonal value $\in[0\%, 100\%]$ ;
$k_i \in R_0^+$ are selectable parameters and
$g(x)$ is a differentiable function with $0.9 \leq g(x) \leq 1.1$ and $g(-1)=g(1)=0$.

5. Screen according to one of Claims 1 to 3, characterized in that the boundary lines (141-144) of a screen dot (14; 14'), with the exception of the areas of the sharp corners, are defined mathematically by the function f(x, z) :

$$f(x,z)=\pm z\cdot e^{-\sum_{i=1}^{\infty}k_i\cdot\left(\frac{z}{2}\right)^{2i}};$$

where

e = Euler's number;
$x\in[-0.95, 0.95]$ ;

$$z = 2\cdot\sqrt{\frac{tonal\ value}{100\%}}-1;$$

tonal value $\in [0\%, 100\%]$;
$k_i\in R_0^+$ are selectable parameters.

6. Screen according to one of Claims 1 to 3, characterized in that each screen dot (15) is bounded by four sinusoidal boundary lines (151-154).

7. Screen according to one of Claims 1 to 6, characterized in that at a relatively low tonal value of a screen dot (14; 14'; 15), the round corners (147, 148) have a relatively large corner radius or the blunt corners (157, 158) include a relatively large angle, and the sharp corners (145, 146; 155, 156) include a relatively small angle.

8. Screen according to one of Claims 1 to 7, characterized in that each screen dot (14; 14'; 15) is arranged within its screen cell (13) so as to be rotated with respect to the screen dot (14; 15) with a 100% tonal value, if its tonal value lies in a specific tonal-value range.

9. Screen according to Claim 8, characterized in that the angle of rotation $\alpha$ for

$$z = 2 \cdot \sqrt{\frac{tonal\ value}{100\%}} - 1$$

is defined as follows:

$$\forall\ z < z_{min}: \qquad \alpha = 0°$$

$$\forall\ z\ with\ z_{min} \leq z < z_{wp}: \qquad \alpha = \alpha_{max} \cdot \frac{z - z_{min}}{z_{wp} - z_{min}}$$

$$\forall\ z\ with\ z_{wp} \leq z \leq z_{max}: \qquad \alpha = \alpha_{max} \cdot \frac{z_{max} - z}{z_{max} - z_{wp}}$$

$$\forall\ z > z_{max}: \qquad \alpha = 0°$$

where $z_{min}$, $z_{max}$, $z_{wp}$ and $\alpha_{max}$ are selectable parameters with $0 \leq z_{min} < z_{wp} < z_{max} \leq 1$ and $\alpha_{max} \in [0°, 180]$ and, in particular, $z_{min}$ can be 0.183 and/or $z_{max}$ can be 0.612 and/or $z_{wp}$ can be 0.414 and/or $\alpha_{max}$ can be 15°.

**10.** Screen according to one of Claims 1 to 7, characterized in that the connecting line between the two mutually opposite corners of the screen dots (14; 14'; 15) in two diagonally adjacent screen cells (13) goes through the common corner of the two screen cells (13).

**11.** Method for the simulation of halftone values on a printing medium (4), characterized in that a screen according to one of Claims 1 co 10 is printed on the printing medium (4).

**Revendications**

**1.** Trame de simulation des valeurs tonales sur un support d'impression (4), comprenant une pluralité de cellules de trame (13) imaginaires, disposées en damier et dans chacune desquelles est disposé un point de trame (14 ; 14' ; 15), caractérisée en ce que les points de trame (14 ; 14' ; 15) sont formés et disposés de telle sorte que, quelle que soit la valeur tonale, identique pour toutes les cellules de trame (13), la plus petite distance avec le point de trame (14 ; 14' ; 15) contigu est toujours identique pour tous les points de la ligne de démarcation (141-144 ; 151-154) d'un point de trame (14 ; 14' ; 15).

**2.** Trame selon la revendication 1, caractérisée en ce que chaque point de trame (14 ; 14' ; 15) présente une surface sensiblement rhomboïdale, dont les lignes de démarcation (141-144; 151-154) suivent un tracé courbe de telle sorte qu'elles forment deux coins pointus (145, 146) diagonalement opposés et deux coins arrondis (147, 148) ou obtus (157, 158) diagonalement opposés.

**3.** Trame selon la revendication 1 ou 2, caractérisée en ce que les lignes de démarcation (141-144 ; 151-154) d'un point de trame (14 ; 14' ; 15), situées en regard l'une de l'autre, sont parallèles entre elles.

**4.** Trame selon l'une quelconque des revendications 1 à 3, caractérisée en ce que les lignes de démarcation (141-144 ; 151-154) d'un point de trame (14 ; 14' ; 15) sont définies mathématiquement par la fonction f(x,z) suivante :

$$f(x,z) = \pm\ z\ \cdot e^{-\sum_{i=1}^{n} k_i \cdot \left(\frac{x}{2}\right)^{2i}} \cdot g(x)\ ;$$

dans laquelle

e = nombre d'Euler ;
x ∈ [-1, 1] ;

$$z = 2 \cdot \sqrt{\frac{\text{valeur tonale}}{100\%}} - 1 \; ;$$

valeur tonale ∈ [0 %, 100 %] ;
$k_i \in R_0^+$

sont des paramètres pouvant être sélectionnés et g(x) est une fonction différentiable avec $0.9 \leq g(x) \leq 1.1$ et g(-1) = g(1) = 0.

5.  Trame selon l'une quelconque des revendications 1 à 3, caractérisée en ce que les lignes de démarcation (141-144) d'un point de trame (14; 14'), à l'exception des zones dans les coins pointus, sont définies mathématiquement par la fonction f(x,z) suivante :

$$f(x, z) = \pm z \cdot e^{-\sum_{i=1}^{5} k_i \cdot \left(\frac{x}{z}\right)^{2i}} \; ;$$

dans laquelle

e = nombre d'Euler ;
x ∈ [-0.95, 0.95] ;

$$z = 2 \cdot \sqrt{\frac{\text{valeur tonale}}{100\%}} - 1 \; ;$$

valeur tonale ∈ [0 %, 100 %] et
$k_i \in R_0^+$

sont des paramètres pouvant être sélectionnés.

6.  Trame selon l'une des revendications 1 à 3, caractérisée en ce que chaque point de trame (15) est délimité par quatre lignes de démarcation (151-154) de forme sinusoïdale.

7.  Trame selon l'une des revendications 1 à 6, caractérisée en ce que si la valeur tonale d'un point de trame (14 ; 14' ; 15) est plus faible, les coins arrondis (147, 148) ont un rayon de courbure plus grand ou les coins obtus (157, 158) forment un angle plus grand et les coins pointus (145, 146 ; 155, 156) forment un angle plus petit.

8.  Trame selon l'une des revendications 1 à 7, caractérisée en ce que chaque point de trame (14 ; 14' ; 15) à l'intérieur de sa cellule de trame (13) est disposé en position pivotée par rapport au point de trame (14 ; 15) avec une valeur tonale égale à 100 %, si sa valeur tonale est située dans une zone de valeur tonale déterminée.

9.  Trame selon la revendication 8, caractérisée en ce que l'angle de rotation $\alpha$ est défini pour

$$z = 2 \cdot \sqrt{\frac{\text{valeur tonale}}{100 \%}} - 1,$$

selon les formules suivantes :

$$\forall \, z < z_{min} : \qquad \alpha = 0°$$

$$\forall\ z\ \text{avec} <z_{min}\leq z < z_{wp}: \qquad \alpha = \alpha_{max} \cdot \frac{z - z_{min}}{z_{wp} - z_{min}}$$

$$\forall\ z\ \text{avec} <z_{wp} \leq z \leq z_{max}: \qquad \alpha = \alpha_{max} \cdot \frac{z_{max} - z}{z_{max} - z_{wp}}$$

$$\forall\ z > z_{max}: \qquad \alpha = 0°$$

dans lesquelles $z_{min}$, $z_{max}$, $z_{wp}$ et $\alpha_{max}$ sont des paramètres pouvant être sélectionnés à condition que $0 \leq z_{min} < z_{wp} < z_{max} \leq 1$ et $\alpha_{max} \in [0°, 180]$ et, en particulier, $z_{min} = 0.183$ et/ou $z_{max} = 0.612$ et/ou $z_{wp} = 0.414$ et/ou $\alpha_{max} = 15°$.

10. Trame selon l'une des revendications 1 à 7, caractérisée en ce que les lignes de liaison des deux coins opposés des points de trame (14 ; 14' ; 15) dans deux cellules de trame (13) diagonalement contiguës passe par le coin commun des deux cellules de trame (13).

11. Procédé de simulation des valeurs tonales sur un support d'impression (4), caractérisé en ce qu'une trame selon l'une des revendications 1 à 10 est imprimée sur le support d'impression (4).

# FIG.1

FIG.2

13

14

141

144

143    142

FIG.3

f(x,z)    148    141    14    145    x

1    1

144    0    142

146    147

-1    -1

143

FIG.4

FIG.5

# FIG.6

14   A   B

10%  15%  20%  25%  30%  35%  40%  45%  50%  55%  60%  65%  70%  75%  80%

EP 0 825 490 B1